Europäisches Patentamt

European Patent Office

Office européen des brevets

(19)

(11) Publication number: 0 354 148
A2

(12) **EUROPEAN PATENT APPLICATION**

(21) Application number: **89420359.5**

(22) Date of filing: **17.05.82**

(51) Int. Cl.⁵: **G 03 B 41/00**
**G 03 F 7/20**

(30) Priority: **15.05.81 US 264171   14.05.82 US 378370**
**15.05.81 US 264249**

(43) Date of publication of application:
**07.02.90 Bulletin 90/06**

(84) Designated Contracting States: **FR**

(60) Publication number of the earlier application in
accordance with Art. 76 EPC: **0 078 323**

(71) Applicant: **GENERAL SIGNAL CORPORATION**
**PO Box 10010 High Ridge Park**
**Stamford Connecticut 06904 (US)**

(72) Inventor: **Hershel, Ronald S.**
**4828 Springhill Road**
**Albany Oregon 97321 (US)**

**Lee, Martin B.**
**13350 Via Arriba Avenue**
**Saratoga California 95070 (US)**

(74) Representative: **Karmin, Roger et al**
**Cabinet MONNIER 150, Cours Lafayette**
**F-69003 Lyon (FR)**

(54) **Apparatus for projecting a series of images onto dies of a semiconductor wafer.**

(57) Improved apparatus for use in a microlithography system to align a semiconductor wafer having a plurality of dies, each die having fiducial marks, with the projected image of at least one pattern having further fiducial marks comprising :
means (34-47) for directing a beam of light toward a reticle (20) ;
shutter (43) means having an aperture for permitting a fraction of said beam to illuminate the fiducial marks of the reticle pattern (20) ;
a projection lens comprising :
a spherical concave mirror (52) having an aperture (58) on its optical axis (51) ;
a meniscus lens (53) having a first convex surface (D) facing said mirror and a concave surface (C) facing away from said mirror ;
a plano-convex lens (55) having a second convex surface facing said concave surface (D) and a first flat surface (B) facing away from said mirror ;
and first and second prisms (56, 57) for coupling light into and from separate fields on said first flat surface, each of said prisms having an optical path length and a second flat surface (A) facing one of the image and object planes of said projection lens, said image and object planes being spaced from said second flat surfaces, whereby said fraction of said beam passes through a reticle (20) positioned at the object plane to illuminate a wafer positioned at the image plane ;
means for moving a wafer in said image plane to align the projected image of the fiducial marks of the reticle patterns with the further fiducial marks of a die on said wafer, and
means (66) for detecting light scattered through said aperture (58) of said mirror (52) and for stopping said moving means when said protected image aligns with said further fiducial marks, characterized in that said shutter means comprises a filter for preventing passage of that portion of the spectrum of said beam normally used to expose a die (12) for microlithographic printing.

Fig. 5.   Fig. 4.

**Description**

## Technical Field

The invention concerns apparatuses for microlithographically forming patterns on semiconductor wafers. More particularly, the invention concerns an improved system for one-to-one projection of pattern images onto a predetermined focal plane.

Background Art

The fabrication of integrated circuits requires a method for accurately forming patterns on a semiconductor wafer. A photoengraving process known as photolithography, or simply masking, is widely employed for this purpose. The microelectronic circuit is built up layer by layer, each layer being based on a pattern received from a photolithographic mask. Such masks typically comprise a glass plate approximately the size of a wafer, the plate having a single pattern repeated many times over its surface. Each repeated pattern corresponds to a pattern to be imposed upon a layer of a wafer.

The mask patterns are derived from an optical reticle having a primary pattern which may be generated by a computer controlled light spot or electron beam which is scanned across a photosensitive plate. The reticle pattern is typically ten times the final size of the pattern to be imposed on the wafer. An image one-tenth the size of the reticle pattern is projected optically on the final mask. The reticle pattern is reproduced side by side many times on the mask, in a step-and-repeat process. Recent advances in reticle production have made it possible to produce reticles having patterns the same size as the final pattern. If such a reticle pattern could be aligned and focused onto a wafer, the mask fabrication could be substantially simplified or entirely eliminated thereby achieving a substantial savings.

The photolithographic process requires that each pattern on the mask be positioned accurately with respect to the layers already formed on the surface of the wafer. One technique is to hold the mask just off the surface of the wafer and to visually align the mask with the patterns in the wafer. After alignment is achieved, the mask is pressed into contact with the wafer. The mask is then flooded with ultraviolet radiation to expose photoresist on the surface of the wafer. The space between the wafer and the mask is often evacuated to achieve intimate contact ; atmospheric pressure squeezes the wafer and the mask together. The latter apparatus is typically known as a contact printer. One defect of contact printers is that the masks quickly become abraded and useless. Since mask fabrication is expensive, it would be desirable to have another method that did not wear out the mask.

In view of the foregoing, a recent trend has been toward a technique known as projection alignment, in which an image of the mask pattern is projected onto the wafer through an optical system. In this case, mask life is virtually unlimited. However, one drawback has been that wafer sizes have been increasing, and the task of designing optics capable of projecting an accurate image over the larger area is becoming more difficult. Another drawback is the moveable projection optical system used in some machines for focusing a projected image onto a wafer. It is often difficult to focus such moveable optical systems and to hold the system in focus.

Recent projection aligners have attempted to circumvent the extreme difficulty of constructing a lens capable of resolving micrometer-sized features over an area of many square inches. A much smaller area, on the order of one square centimeter, is exposed, and the exposure is repeated by stepping or scanning the projected image of the mask pattern over the wafer. Such machines are known as projection steppers. So far, all of the efforts to provide commercially acceptable projection steppers have been less than satisfactory. The use of one-to-one, or unit magnification, projection optics has become more frequent in such systems ; however, achieving an adequately corrected, suitably large field in such systems has continued to present problems to those working in the art. As a result, a need has continued to exist for a projection stepping machine capable of using the now available, smaller reticles for directly forming patterns on wafers, thereby eliminating the need for a large, multiple pattern mask.

Unit magnification catadioptric lens system have been used in a variery of applications. U.S. Patent N° 2 742 817 disclosed different types of unit magnification lenses, including one in which a concave spherical mirror was combined with a plano-convex lens, the lens being positioned between the mirror and the center of curvature of the mirror. The radius of curvature of the plano-convex lens was chosen so that it did not coincide with the center of curvature of the mirror, and the index of refraction and dispersion power of the lens were chosen so that the Petzval sum of the lens was numerically equal to the curvature of the mirror. The patent indicates that the single plano-convex lens can be replaced by a cemented doublet in order to achieve color correction but that in such a simple system, considerable difficulty is encountered in correcting various aberrations. The use of an achromatic doublet was said to permit the lens to be placed closer to the focal plane than would use of a single plano-convex lens.

An article entitled "Unit Magnification Optical System Without Seidel Aberrations" was published in July, 1959 in Volume 49, N° 7 Of the Journal of the Optical Society of America at pages 713 - 716. The author, J. Dyson, disclosed that when the radius of a concave mirror and a plano-convex lens are chosen so that the upper principle focus of the lens lies on the surface of the mirror and so that the centers of curvature of the spherical surfaces coincide, then the flat face of the plano-convex lens will be a common object/image plane for the system. The sagittal image plane is flat ; whereas, the tangential surface is a fourth order curve. The use of prisms to couple light into and out of the lens was disclosed, as was the use of a small air gap between the prism face and image/object surface. Such an air gap was said to introduce spherical and chromatic aberrations of a sense opposite to those provided by the lens so that by proper choice of the gap thickness and glass type, the author asserted, it would be possible to correct both types of aberrations simultaneously.

An article entitled "A Unit Power Telescope for Projection Copying" by C. G. Wynne appeared in 1969 in a book entitled Optical Instruments and Techniques at pages 429 - 434. A projection system was disclosed for use in making microcircuits by projection lithography. A concave spherical mirror, a meniscus lens, a plano-convex lens and a beam splitter were used. To correct the lens for both projection and alignment wavelengths, all spherical surfaces were required to be concentric ; the material of the meniscus lens had to have a higher dispersion than that of the plano-convex lens ; and to achieve chromatic correction of the Petzval curvature, the lenses had to have the same mean refractive index but different dispersions. The use of an air gap between the object/image planes and the surfaces of the beam splitter was disclosed. The author noted that "the spherical aberration caused by introducing a plane parallel air space is of opposite sign to that caused by introducing a plane parallel plate of higher refractive index. The Seidel Spherical aberration of the plane parallel air space... can therefore be corrected by making the beam splitter cube of slightly higher refractive index than that of the plano-convex lens to which it is cemented ; and by an appropriate choice of glass dispersion, chromatic aberration can be corrected at the same time. The higher orders of spherical aberration cannot be corrected, but for small air spaces, the uncorrected residuals are very small". The Wynne lens provided improved correction over a larger field ; however, the lens was quite bulky, the air gap at the image and object planes was rather small and the orientation of the image and object planes made use of the lens rather impractical in a projection stepping system. A variation of the Wynne system is shown in U.S. Patent N° 3 536 380 which disclosed a unit magnification lens in which the spherical surfaces are all concentric.

Disclosure of the Invention

The invention provides an apparatus for projecting an image of a reticle pattern onto a wafer, with one-to-one magnification. The apparatus includes means for holding a reticle containing a pattern corresponding to the size of the desired wafer pattern. An illumination system substantially uniformly illuminates the reticle pattern. A stationary one-to-one projection optical system projects an image of the reticle pattern onto a predetermined focal plane. Suitable means such as a vaccum chuck holds the wafer. An alignment system steps and orients the wafer chuck to register markings on the individual dies of the wafer with corresponding markings on the projected image of the reticle pattern. A fluid servo system acts on the chuck to hold at least a portion of the wafer in the predetermined focal plane of the projection optical system.

The present invention is relating to :
an improved apparatus for use in a microlithography system to align a semiconductor wafer having a plurality of dies, each die having fiducial marks, with the projected image of at least one pattern having further fiducial marks, said apparatus comprising :
means for directing a beam of light toward a reticle ;
shutter means having an aperture for permitting a fraction of said beam to illuminate the fiducial marks of the reticle pattern ;
a projection lens comprising :
a spherical concave mirror having an aperture on its optical axis ;
a meniscus lens having a first convex surface (D) facing said mirror and a concave surface (C) facing away from said mirror ;
a plano-convex lens having a second surface facing said concave surface (D) and a first flat surface (B) facing away from said mirror ;
and first and second prisms for coupling light into and from separate fields on said first flat surface, each of said prisms having an optical path length and a second flat surface (A) facing one of the image and object planes of said projection lens, said image and object planes being spaced from said second flat surfaces, whereby said fraction of said beam passes through a reticle positioned at the object plane to illuminate a wafer positioned at the image plane ;
means for moving a wafer in said image plane to align the projected image of the fiducial marks of the reticle patterns with the further fiducial marks of a die on said wafer, and
means for detecting light scattered through said aperture of said mirror and for stopping said moving means when said protected image aligns with said further fiducial marks, characterized in that said shutter means comprises a filter for preventing passage of that portion of the spectrum of said beam normally used to expose a die for microlithographic printing.

Brief Description of the Drawings

Figure 1 is a plan view of a typical wafer having a plurality of dies formed thereon.

Figure 2 is an enlarged fragmentary view of the wafer of fig. 1, showing the dies on the wafer and the fiducial markers on the dies.

Figure 3 is a perspective, schematic view of a projection stepper.

Figure 4 is an optical schematic view of the illumination system of the projection stepper.

Figure 5 is an optical schematic view of the projection system and fiducial marker detection system of the projection stepper.

Figure 6 is a front elevational view of the reticle and apparatus for holding and advancing the reticle, taken on line 6-6 of fig. 12.

Figure 7 is a partiel front elevational view of the projection stepper showing the illumination system and portions of the projection system in phantom lines.

Figure 8 is a partial sectional view taken allong the line 8-8 of figure 7 showing the optical projection and alignment systems in phantom lines.

Figure 9 is a simplified, enlarged, partial perspective view of the illumination and projection optical system.

Figure 10 is a elevation sectional view of the optical illumination system, taken on line 10-10 of fig. 12.

Figure 11 is an elevation, partially sectional view taken on line 11-11 of fig. 7 of the optical projection systelm and portions of the wafer platform, the photomultiplier assembly, and the illumination system.

Figure 12 is a partial sectional view of the illumination and projection optical systems.

Figure 13 is a detailed plan view of the wafer platform with portions of the focusing system shown in phantom, taken on line 13-13 of fig. 11.

Figure 14 is a planar view of the exposure area of the projection optical system.

Figure 15 is an exploded view of the photomultiplier stage.

Best Mode for Carrying Out the Invention

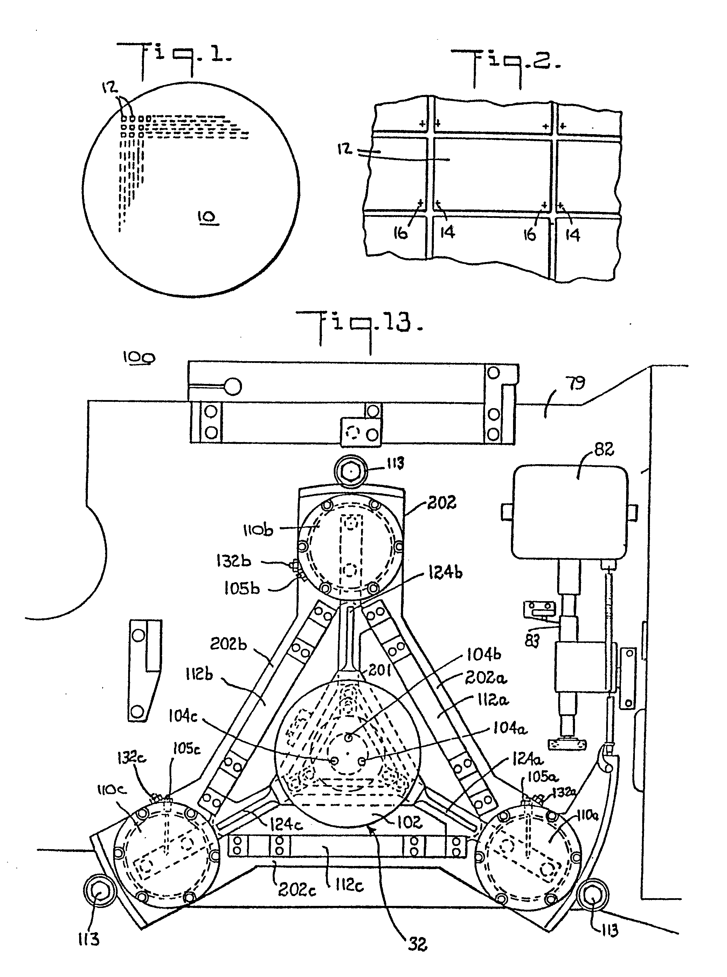

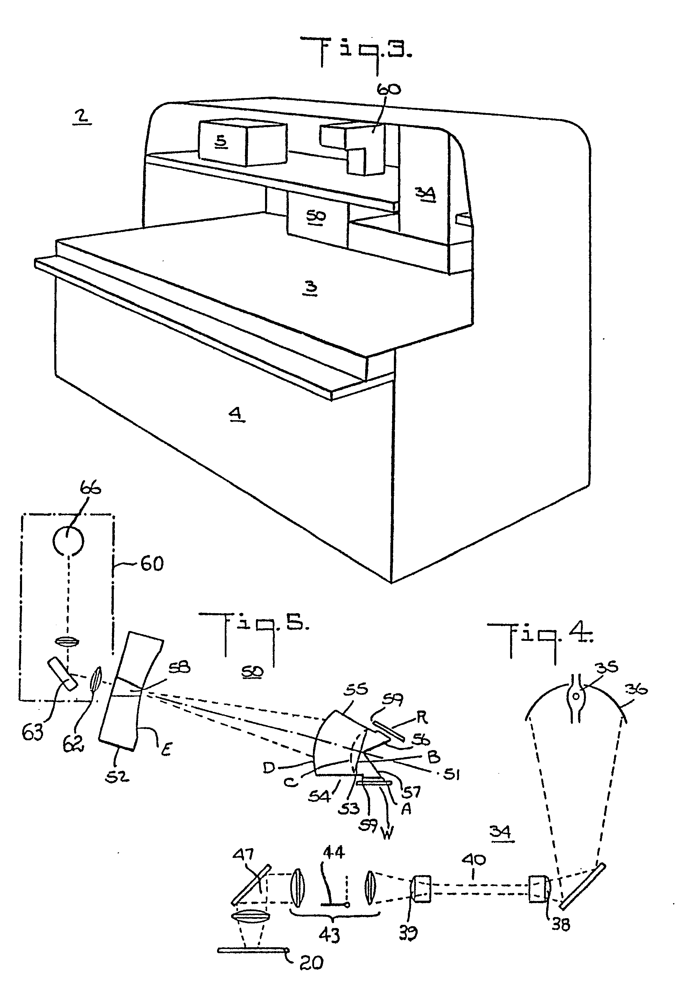

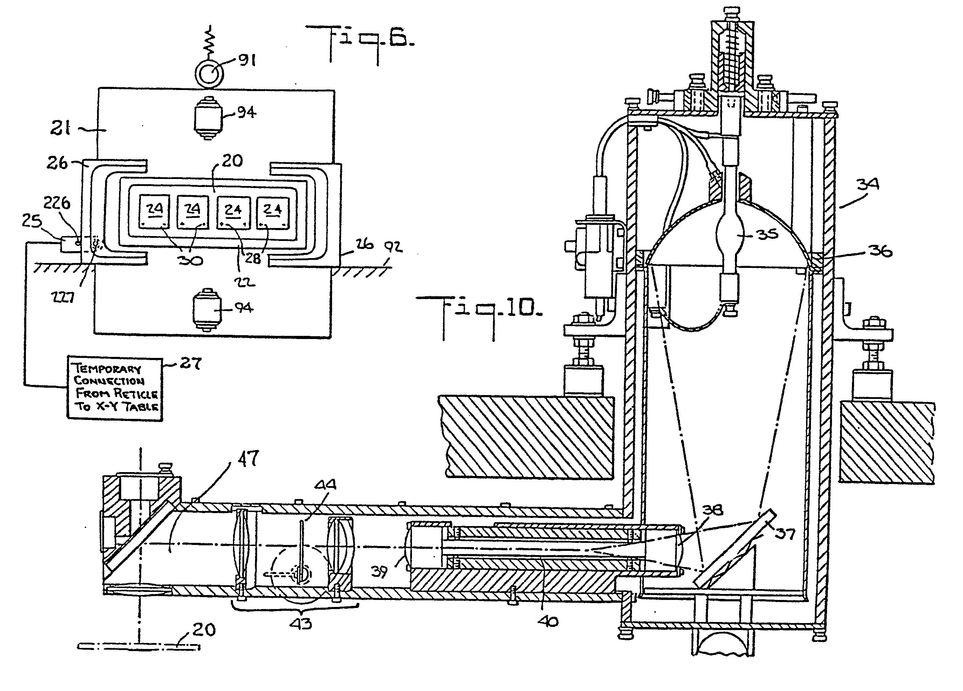

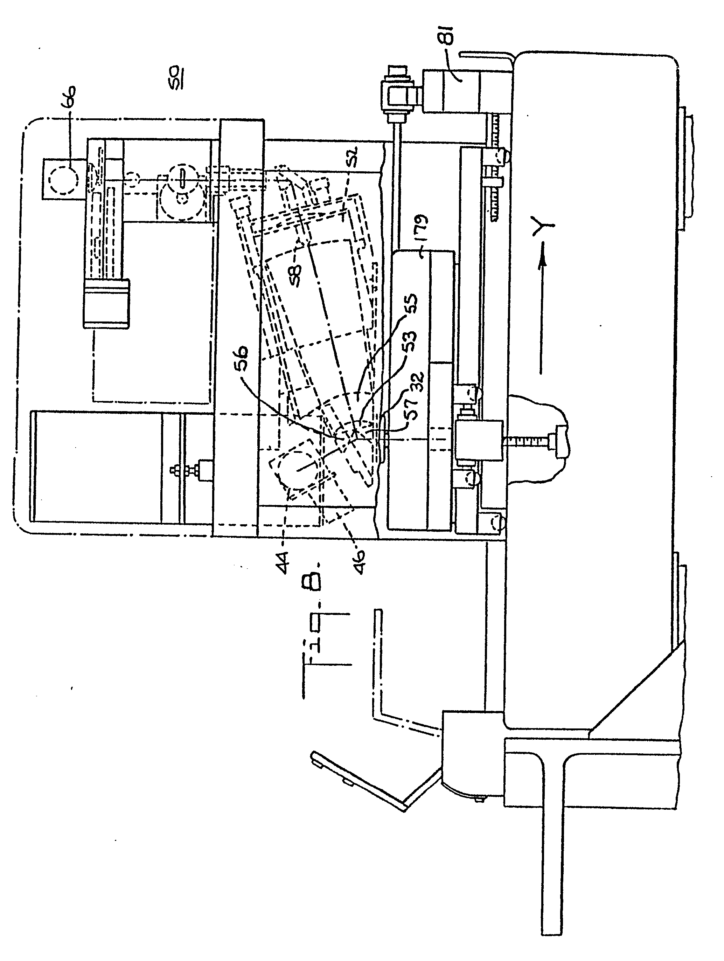

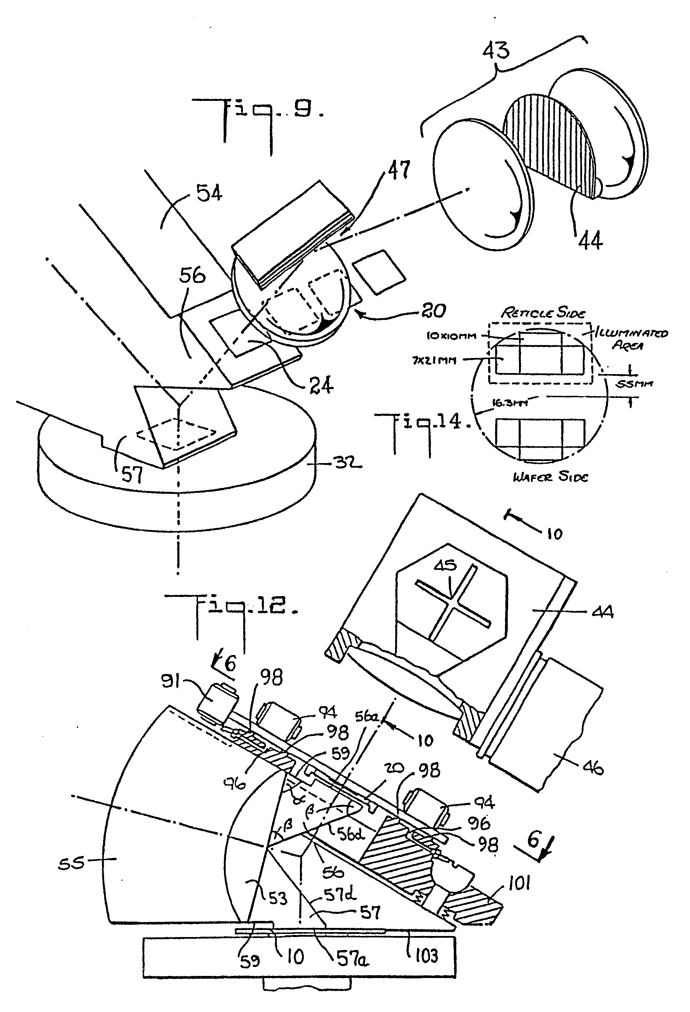

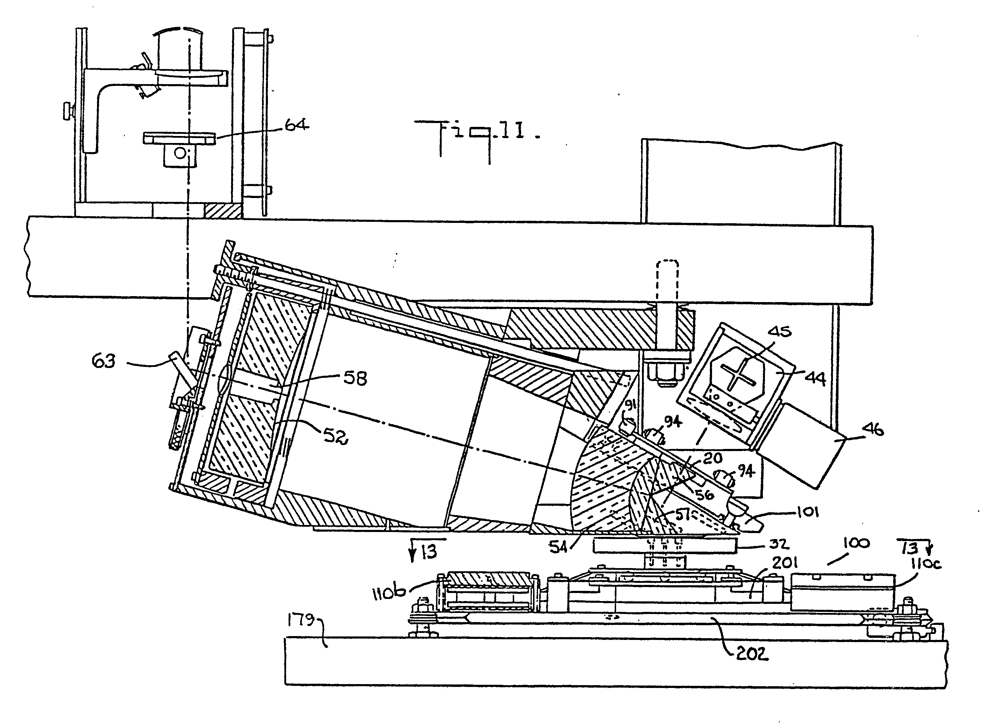

Figures 3 and 7 show a perspective and front elevation view of a projection stepping machine according to the invention. A shelf 3 supports a wafer positioning system 79 including a chuck 32 shown in figs. 7, 9, 11 and 13. Underneath the shelf 3 is space 4 to hold power supplies and a computer (not shown). Above the shelf 3 are the illumination system 34, projection system 50, a dark field automatic alignment system 60, and a cathode ray tube display 5 for monitoring the alignment system 60.

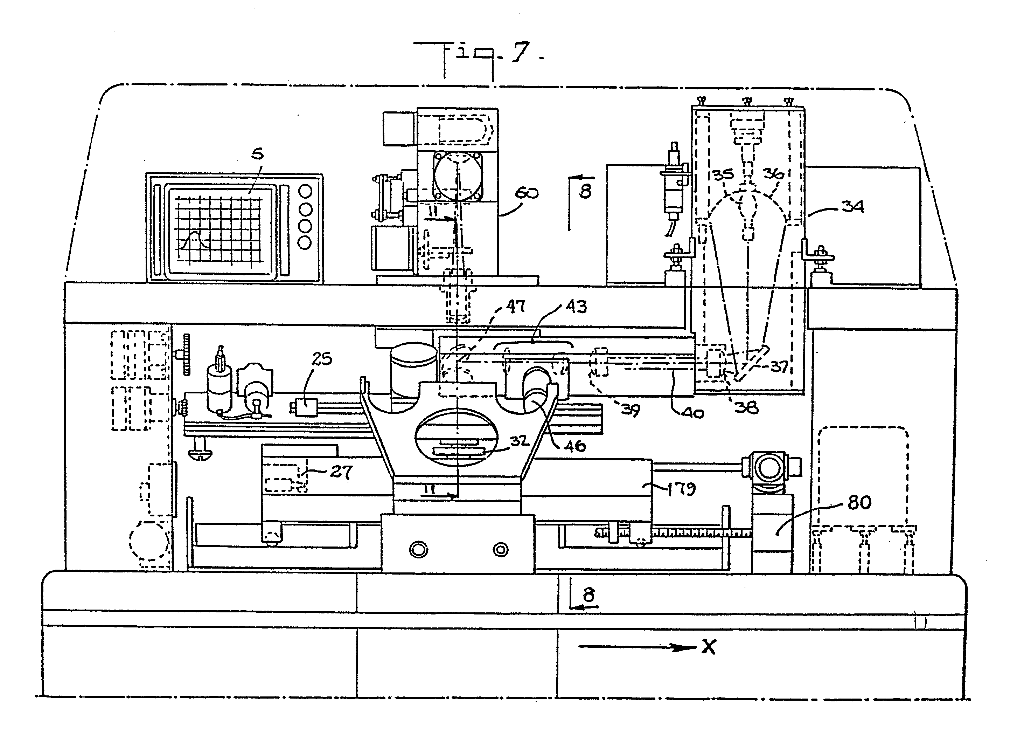

In operation a reticle 20 shown in Figs 6 and 9-12 is disposed between illumination system 34 and projection system 50. Alignment system 60 controls the movement of the wafer positioning system 79 to align the dies 12 of a wafer 10 shown in figs. 1 and 2 with the projected image of the pattern on reticle 20. A focusing system 100 shown in fig. 11 maintains the projected image of the reticle pattern in optimam focus on the wafer. The power output of illumination system 34 is increased to develop the exposed (non imaged) areas of the dies 12. After exposure, the wafer positioning system is moved or stepped to bring another portion of the wafer 10 into alignment and focus with the projected reticle image.

Figures 1 and 2 show a wafer 10 provided with a plurality of dies 12 arranged in rows and columns. Each die 12 has a pair of fiducial markers 14 and 16 at adjacent or opposite corners of the die. The markers 14 and 16 may be in the form of small " + " signs. As will be described in detail hereinafter, the markers 14 and 16 are used to align the dies with the projected image of the reticle pattern.

Stepping machine 2 also includes a reticle 20 shown in figs. 6 and 9 - 12. Reticle 20 is mounted in a frame 22 and has a plurality of patterns 24 arranged in a row within the frame. Frame 22 in turn is disposed between a pair of oppositely opening reticle guides 26. A pellicle (not shown) covers the reticle 20. A pellicle is a thin, transparent membrane which seals off the reticle surface from dust and other contaminants. The pellicle is held in frame 22 at a predetermined distance from the surface of patterns 24 so that the projected reticle image is practically unaffected by contaminants adhering to the pellicle.

Each pattern 24 has a pair of fiducial markers 28 and 30 at adjacent or opposite corners of the pattern in a manner similar to the markers 14 and 16 on dies 12. The markers 14 and 16 on each individual die are respectively aligned with the markers 28 and 30 of the projected images of reticle 20 before the image of that reticle is printed on each individual die.

Wafer Positioning System

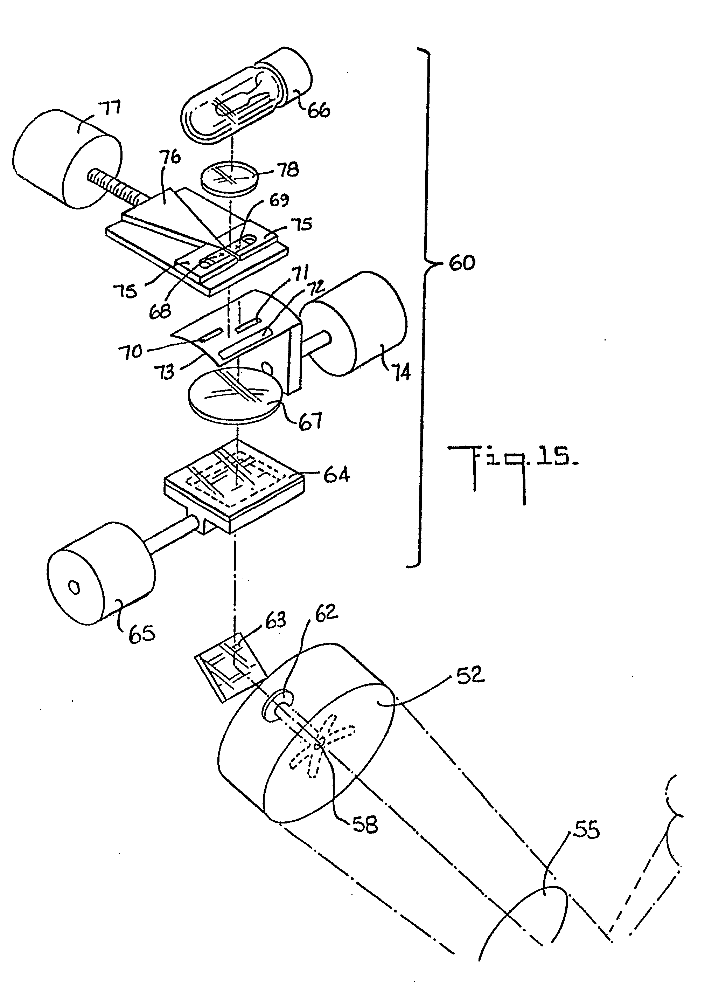

Holding means, such as a vacuum chuck 32 shown in figs. 6 - 8, 7 - 8, 11, 12 and 13, is disposed below projection system 50. Chuck 32 is moveable rectilinearly in two coordinate directions, such as X and Y directions, to align one of markers 14, 16 on the dies 12 with one markers 28, 30 on the projected images of reticle 20. The chuck is also rotatable in the same plane as that defined by the X and Y directions, to align the other of markers 14, 16 on the dies 12 with the other of markers 28, 30 on the projected images of reticle 20. Chuck 32 is also moveable vertically to provide an optimal focusing of the projected images on the dies 12, as will be discussed subsequently. The chuck 32 is provided on its upper surface with a plurality of concentric narrow lapped lands 302 shown in fig. 8. Relatively wide grooves 303 separate lands 302 for wringing in the wafer 20 to lie substantially flat on lands 302 as described bereinafter.

A reticle illumination system 34, shown in fig. 3 - 5, 7 - 10 and 15, comprises a light source 35 such as a mercury short arc lamp having rating of 200 W. The mercury lamp is pulsed at 500 W during wafer exposure and held at a standby power of 100 W during alignment and other operations. Thus, the average power consumption of the lamp during a typical wafer stepping operation is approximately 200 W.

An elliptical reflector 36 focuses the arc image of the lamp onto one end of a light pipe 40. A dichroic mirror 37 reflects only a selected wavelength band of light, thereby preventing the infrared and ultraviolet portions of the lamp spectrum from reaching the reticle. Hemispheric lenses 38, 39 are cemented to opposite ends of the light pi pe 40 which aid the coupling of the light in and out of the pipe 40 as well as protect the end faces thereof. Light leaves the light pipe 40, passes through lens 39 and a shutter stator 43 having moveable shutter 44, and a lens and mirror arrangement 47 for illuminating the reticle 20.

The function of the light pipe 40 is to efficiently convert the nonuniform intensity distribution of light at the lamp end to a uniform distribution of light at the reticle end. Internal reflections within the light pipe are essentially lossless. The incoming light is folded and integrated with each internal reflection, thereby reducing nonuniformities. A main advantage of the light pipe 40 is that misalignment of the lamp or light source 35 merely reduces the total output intensity without noticably affecting the uniformity.

After a predetermined exposure, monitored by a detector (not shown) located near the output of illumination system 34, the lamp power is dropped to 100 W and simultaneously shutter 44 is moved into the aperture plane. A small fraction of the light from source 35 passes through a cross opening 45 in shutter 44 and illuminates the marker 28, 30 on the reticle 20. A high pass dielectric filter (not shown) covers the opening 45 to prevent the g and h lines from exposing the wafer during alignment. On certain wafer levels, it may be necessary to use the mercury g line to enhance the alignment signal. In this case, it can be shown that the relative exposure value of the intensity reaching the wafer is 2% during normal exposure.

The exposure area shown in fig. 14 has a circular perimeter with a 16.3 mm radius and a cord 5.5 mm from the center. To insure uniform resolution out to the corners of the exposure area, the perimeter radius is purposely chosen 0.5 mm smaller than the design field height H to provide a margin of safety for errors in fabrication and reticle placement. The constraint imposed by the cord insures clear passage through the prisms of all rays originating from the lower edge of the reticle field. As shown in fig. 14, the largest square area permitted with the above constraints is 10 X 10 mm. Also shown is the largest available aspect ratio of 3:1, corresponding to a 7 X 21 mm exposure area. The user can choose from a continuous selection of aspect ratios between these two extremes with the toal area per exposure ranging from 1 cm² to slightly under 1.5 cm².

Choosing the larger areas can substantially reduce the number of exposure steps required to cover a 10.16 cm wafer. For example, a 2 X 8 die array with a 0.262 X 0.351 cm pitch will fit into the 7 X 21 mm exposure area, requiring 51 steps to cover a 10.16 cm wafer. If the pitch were changed to 0.401 X 0.457 cm, one could fit a 2 X 4 array into an 8 X 18.3 mm exposure area, requiring only 48 steps to cover a 10.16 cm wafer. In both examples, over 90 exposures per 10.16 cm wafer would be required with the 14-14.5 mm diameter fields available with current 10:1 projection lenses.

Alignment system 60 comprises the necessary optical and mechanical features to enable the stepping machine to adjust itself for different size recticle patterns and for reticle assembly errors. See fig. 7, 8, 11, and 15. Starting at spherical mirror 52, light which was scattered into the dark central cone by the frosty wafer or a fiducial marker passes through aperture 58, which formed the dark cone. The light beam is partially focussed by a 147 mmf achromat lens 62 and bounced up toward tube 66 by a folding mirror 63.

The beam passes through the tilt window 64 which will refractively shift the image in the Y-direction if tilted by a computer controlled window motor 65. The beam then passes off center through a 200 mmf plano-convex lens 67 to finally focus at the plane of a pair of cross masks 68, 69. The off center passage corrects for color shift introduced when the return beam passed off center through achromat-prism assembly 54.

Before reaching cross masks 68, 69, the beam passes through one of three apertures 70, 71, 72 in a shutter 73 operated by a computer controlled shutter motor 74. Shutter 73 may be positioned so that right or left apertures 70, 71 alternately view reticle fiducial markers 28, 30 or the additional reticle alignment markers or keys previously described. Shutter 73 may also be positioned so that larger aperture 72 views both types of markers at once. The net effect of this to split the difference in alignment error when aligning wafers. Large aperture 72 is fitted with a 50% neutral density filter to maintain constant signal stength at tube 66.

The light beam is focused at the cross masks 68, 69. The purpose of the cross masks is to blank out all light coming up the dark cone except that from the small area around an alignment marker or key. Masks 68, 69 are mounted in cross sliders 75 guided by a straightedge (not shown) and are moved equal distances apart by a wedge 76 driven by a motor 77. The computer can thus select the correct separation for a given set of alignment markers or keys.

After the cross masks the beam begins to spread, so a 38 mmf lens 76 is provided to gather the rays enough to hit the target cathode in photomultiplier tube 66. This tube converts light beam intensity to an electrical signal which is amplified and sent to the computer, in which the raw signal is modified by a zero suppression circuit and amplification gain adjustement to present the signal which the operator may monitor on CRT display 5. By means of a peak detection circuit and a voltage divider, the computer selects a sample point. As an optical image is scanned, the peak is detected and the signal drops to the sample point. The computer collects a position sample from the laser controlled stage. A scan in opposite directions cancels phase (time delay) errors so the computer can take the simple average as the position of an alignment feature. If inspection of the final results indicates a consistent error, the user may enter a compensating offset in the computer software.

Aperture 58 provides a dark cone or field in which light, scattered by one die markers 14, 16 is readily detected by tube 66. As the projected image of one of reticle pattern markers 28, 30 is brought into registration with one of die markers 14, 16 light scattered from the pattern edges of the die marker passes through central aperture 58 in mirror 52, as shown schematically in fig. 5. Such scattered light is transmitted through lens past mirror 63 and through aperture 70 of shutter 73 for detection by photomultiplier tube 66, constructed in the conventional manner to convert received light to a corresponding production of electrons on an amplified basis. This technique provides a high signal to noise ratio, so that alignment accuracy is rather insensitive to defocus. The output of tube 66 is displayed on CRT 5. The signal waveform resembles a parabola as one of alignment marks 14, 16 is scanned along a given axis while being illuminated.

As shown in fig. 7, 8, 11 and 13, chuck 32 is disposed on a platform 179 supported on air bearings in a well known manner. Motors 80 (fig. 7), 81 (fig. 8) and 82 (fig. 13) are respectively associated with the platform 179. Motors 80 and 81 are respectively coupled to the platform 179 to move it horizontally in X and Y coordinate directions in a conventional manner. Motor 82 is coupled to the platform 179 through a lead screw 83 to rotate the platform about a vertical axis extending through the center of the chuck 32.

A computer (not shown) processes the signals produced by the tube 66 to determine the relative coincidence of each marker 14 on die 12 with the projected image of marker 26 on reticle 20. The computer uses these signals to operate the motors 80 and 81 for respectively driving the platform 179 in the X and Y directions to position the image of markers 28 directly in registration with marker 14. Once the wafer 10 is aligned, its position can be subsequently accurately monitored by any suitable means, such as a laser interferometer system (not shown). Such a system will continuously update the computer with signals representative of the change in position of the platform 179.

When accurate registration has been obtained between markers 14 and the image of marker 28, the computer energizes motor 74 for rotating the shutter 73. Shutter 73 moves to a position where aperture 71 is provided for viewing marker 16 on die 12 to determine its registration with the projected image of reticle 20. The computer then causes the motor 82 to drive the platform 179 about the center of the chuck 32 until marker 16 registers with the projected image of marker 30.

The adjustments in the X and Y directions by the motors 80 and 81 and in the polar direction by the motor 82 may be continued until alignment is simultaneously provided between markers 14, 16 and the projected images of markers 28, 30. Upon the occurence of such simultaneous alignments, shutter 44 is opened and source 35 is fully energized to expose die 12 to the projected image of the patterns 24 on reticle 20. The die 12 is thereafter treated (by apparatus not constituting this invention) to produce electrical circuitry in accordance with such image.

The pattern 24 on reticle 20 may be reproduced on a plurality of different dies 12 on the wafer 10. Such reproduction is under the control of the computer. However, before such reproduction takes place, the chuck 32 is repositioned so that the markers 14 and 16 on the next die register with the projected images of the markers 28 and 30 on reticle 20. Such realignment is provided in the manner described above.

As previously described, reticle 20 comprises a transparent glass substrate or plate 21, on which a plurality of patterns 24 are provided. After one of patterns 24 has been reproduced on a particular number of dies 12 in accordance with the controls provided by the computer, reticle 20 may be advanced to the next pattern by a push rod 25 and bell crank mechanism 27 that temporarily couples the reticle to the X/Y platform 79. See. Figs. 6, 7, 9, 11 and 12. Reticle guides 26 are biased by spring loaded roller 91 to bear against the reticle bearing and alignment member 92 shown schematically in fig. 9. Member 92 has a smooth straight bearing surface on which guides 26 may be moved. This arrangement positively locates reticle 20 in one direction. The reticle may be positively located and advanced in the orthogonal direction by the push rod 25 having two closely spaced pins 226, 227. The leading pin 226 bears against the eadge of one guide 26. The other pin 227 sets into a recess provided in reticle guide 26. The bell crank mechanism 27 shown schematically in fig. 10, or other suitable mechanism, selectively couples the push rod 25 to the platform 179 for moving the reticle 20 from one pattern to the next.

The controlled advance of reticle 20 through a distance corresponding to the spacing of patterns 24 is facilitated by the disposition of a pair of spaced rollers 94 that arc spring loaded to bear against reticle 20. This reticle advancing feature facilitates the use of test reticle patterns during printing operation. During movement of reticle 20 from one pattern to the next, pressurized air is applied through ports 96 beneath reticle 20 to displace the reticle 20 into engagement with rollers 94. Upon movement of reticle 20 to the next pattern 24, the flow of pressurized air through the ports 96 is discontinued and a vacuum is applied to the ports. This causes the reticle 20 to become disposed against support surfaces 98 so that patterns 24 will be in a fixed and proper position in the optical path.

## Claims

1. An improved apparatus for use in a microlithography system to align a semiconductor wafer having a plurality of dies, each die having fiducial marks, with the projected image of at least one pattern having further fiducial marks, said apparatus comprising :
means (34-47) for directing a beam of light toward a reticle (20) ;
shutter (43-44) means having an aperture (45) for permitting a fraction of said beam to illuminate the fiducial marks (28-30) of the reticle pattern ;
a projection lens comprising :
a spherical concave mirror (52) having an aperture (58) on its optical axis (51) ;
a meniscus lens (53) having a first convex surface (D) facing said mirror and a concave surface (C) facing away from said mirror ;
a plano-convex lens (55) having a second convex surface facing said concave surface (D) and a first flat surface (B) facing away from said mirror ;
and first and second prisms (56, 57) for coupling light into and from separate fields on said first flat surface, each of said prisms having an optical path length and a second flat surface (A) facing one of the image and object planes of said projection lens, said image and object planes being spaced from said second flat surfaces, whereby said fraction of said beam passes through a reticle (20) positioned at the object plane to illuminate a wafer (10) positioned at the image plane ;
means for moving a wafer (10) in said image plane to align the projected image of the fiducial marks of the reticle patterns with the further fiducial marks of a die on said wafer, and

means (66) for detecting light scattered through said aperture (58) of said mirror (52) and for stopping said moving means when said protected image aligns with said further fiducial marks, characterized in that said shutter means comprises a filter for preventing passage of that portion of the spectrum of said beam normally used to expose a die (12) for microlithographic printing.

2. Apparatus according to claim 1, characterized in that said means for detecting comprises means for correcting for color shift introduced when said scattered light passes through said projection lens.

3. Apparatus according to claim 1, characterized in that said means for detecting comprises a plurality of apertures (70-72) selectively positionable to pass light scattered from fiducial marks on predetermined areas of said die (12).

4. Apparatus according to claim 1, characterized in that said means for detecting comprises mask means (68, 69) for blocking all scattered light except that from the area of a die (12) around the projected image of a fiducial mark on the reticle (20), and a photomultiplier (66) for detecting the intensity of light passing said mask means.

5. Apparatus according to claim 1, characterized in that said correcting means comprises means for shifting said scattered light away from said optical axis and lens means for receiving said scattered light after said shifting so that said scattered light passes off-center through said lens means.

6. Apparatus according to claim 1, characterized in that it comprises means including spaced apertures (70-72) selectively positionable to pass light scattered through said aperture (58) of said mirror (52) by said wafer means (10) from the projected image of the spaced fiducial marks of the reticle pattern ;

means for moving the reticle (20) in the object plane to align the projected image of the spaced fiducial marks of the reticle pattern with said spaced apertures ; and

means (66) for detecting light passed through said spaced apertures and for stopping said moving means when said projected image aligns with said spaced apertures (70-72).

7. Apparatus according to claim 6, characterized in that said means for detecting comprises a plurality of further apertures selectively positioned to pass light scattered from preselected projected images of the fiducial marks of the reticle pattern.

# Fig.1.

12

10

# Fig.2.

12

16    14    16    14

# Fig.13.

100

79

113

202

110b

132b

105b

124b

82

83

202b

112b

104c

201

104b
202a
112a

104a

105c

132c

105c

110c

132a
105a

124a

124c

102

110a

202c    112c

32

113

113

Fig.3.

Fig.5.

Fig.4.

Fig.6.

91

94

21

26

20

226

24 24 24 24

25

30 28 26 92

227 22

94

Fig.10.

34

35

36

27

TEMPORARY CONNECTION FROM RETICLE TO X-Y TABLE

47

44

38

37

39

43

40

20

EP 0 354 148 A2

Fig. 7.

Fig. 8.

Fig.9.

43

54

47

44

56

20

24

32

Fig.14.

RETICLE SIDE

10x10MM

7x21MM

ILLUMINATED AREA

55MM

16.3MM

57

WAFER SIDE

Fig.12.

10

45

44

6

91

98

94

56a

10

98

59

96

20

98

96

98

55

β

α

β

94

56d

6

56

101

53

57d

57

59

10

57a

103

Fig.11.

Fig.15.